# FASCICULE DE BREVET EUROPEEN

(11) **EP 0 717 442 B1**
(45) Date de publication et mention de la délivrance du brevet: **04.10.2001**
(21) Numéro de dépôt: 95402812.2
(22) Date de dépôt: 14.12.1995
(51) Int. Cl.: H01L 23/498

(54) **Support de connexion d'un circuit intégré à un autre support par l'intermédiare de boules**
Träger für integrierten Schaltkreis zur Kontaktierung eines anderen Trägers mittels Kontaktkugeln
Integrated circuit support to be connected to another support by means of bumps

(30) Priorité: 16.12.1994 FR 9415202
(43) Date de publication de la demande: 19.06.1996
(73) Titulaire: BULL S.A., 78430 Louveciennes (FR)
(72) Inventeur: Dehaine, Gérard, F-92320 Chatillon (FR); Stricot, Yves, F-78340 Les Clayes sous Bois (FR)
(74) Mandataire: Denis, Hervé

(56) Documents cités:
- EP-A- 0 011 013
- EP-A- 0 356 300
- EP-A- 0 527 387
- US-A- 5 045 921
- US-A- 5 127 570
- US-A- 5 203 075
- IBM TECHNICAL DISCLOSURE BULLETIN, vol. 31, no. 6, Novembre 1988 NEW YORK US, pages 335-336, XP 000054208 'Improved Method for C-4 Chip Join'

## Description

### Domaine technique

L'invention se rapporte à un support de connexion d'un circuit intégré à un autre support par l'intermédiaire de boules. Elle a plus particulièrement pour objet un support de connexion de circuit intégré, comprenant un film isolant dont une face porte des conducteurs et l'autre face porte des boules reliées aux conducteurs respectifs par l'intermédiaire de traversées ménagées dans le film. L'invention a aussi pour objet un boîtier de circuit intégré. L'invention s'applique avantageusement à la technologie de connexion par boules en réseau appelée communément technologie BGA (Ball Grid Array) et plus particulièrement celle dite à ruban ou TBGA (Tape BGA).

### L'art antérieur

Dans le support de connexion utilisé ordinairement jusqu'à présent, les traversées ménagées dans le film sont métallisées et présentent chacune une couronne métallisée sur la face du film qui est opposée à celle portant les conducteurs. Sur la couronne est fixée une boule de connexion. Afin que la boule prenne bien appui sur la couronne, la traversée a une section sensiblement plus petite que celle de la boule. Cette liaison a pour inconvénient de nécessiter la métallisation des traversées, qui requiert plusieurs opérations et grève notablement le coût de fabrication du support. D'autre part, la faible section des traversées métallisées présente une self-induction relativement élevée pour les signaux et une résistance non négligeable au passage des courants d'alimentation.

D'autre part, la face qui porte les boules d'un support classique porte souvent une feuille métallique conductrice servant de plaque masse. Cette feuille est connectée aux bords métallisés des traversées destinées aux conducteurs de masse portés par l'autre face du support. Bien sûr, la feuille est percée de trous entourant les bords métallisés des autres traversées de façon à être électriquement isolées d'elles et des boules respectives. Cependant, il faut éviter que la soudure de ces boules s'étende, en coulant par exemple, jusqu'aux bords des trous de la feuille de masse. Une telle extension créerait un court-circuit difficilement réparable, qui obligerait donc à éliminer le support, voire même le boîtier très coûteux. En outre, il faut même éviter que la soudure s'étende près des bords des trous de la feuille de façon à éliminer tout risque de court-circuit. Pour satisfaire à ces contraintes, les boules sont faites en un matériau qui ne refusionne pas lors de leur montage sur le film et qui ne refusionne pas lors du montage sur la carte. De ce fait, les boules gardent sensiblement leurs dimensions après soudure. D'autres raisons font encore que les boules non refusionnables sont couramment employées.

Cependant, l'emploi de boules non refusionnables entraîne d'autres inconvénients. En effet, ces boules servent à fixer le support de connexion du circuit intégré à un autre support de connexion, tel qu'une carte de circuits imprimés pour l'interconnexion de plusieurs circuits intégrés. Les boules sont donc connectées à des plages de connexion disposées coplanairement sur une face de la carte, selon un montage dit de surface et appelé communément CMS (composants montés en surface) ou SMT (Surface Mount Technology). L'emploi de boules non refusionnables requiert donc que les plages de connexion soient pratiquement toutes dans un même plan pour assurer un contact efficace et fiable avec les boules respectives. En d'autres termes, l'emploi de boules non refusionnables nécessite l'utilisation de cartes ayant des marges de tolérance en planéité très contraignantes. A cette limitation de l'application des supports classiques à de telles cartes s'ajoute l'inconvénient du coût nettement supérieur de ces cartes. De surcroît, les boules doivent avoir des dimensions très précises et elles sont montées sur le film qui n'a pas normalement une bonne planéité. Il s'ensuit que les sommets des boules entrent difficilement dans les marges de planéité requise pour une connexion efficace et fiable des boules à la carte. Ceci a pour conséquence de diminuer sensiblement le rendement du montage du support sur la carte.
Le document IBM Technical Disclosure Bulletin Vol. 31, No. 6, Nov 1988, pp335-336 ; "Improved method for C-4 chip join", décrit un support de connexion de circuit intégré comprenant un film isolant en polyimide dont une face porte des conducteurs et l'autre face porte des boules reliées aux conducteurs respectifs par l'intermédiaire de traversées. Les boules sont directement fixées dans lesdites traversées dont le fond est formé par les conducteurs respectifs.
Le document US5045921A décrit également un tel support et décrit en outre la connexion de deux supports par refusion des boules.

Le document US5127570A décrit une connexion d'un support de circuit à un deuxième support, où les boules sont fixées au deuxième support. Selon ce document, les boules fixées au deuxième support facilite l'alignement avec le premier support.

### L'invention

Un des buts de l'invention est d'éviter la métallisation des traversées du film isolant du support de connexion.

Un autre but est de pouvoir éviter l'emploi de boules non refusionnables.

Un autre but aussi est de minimiser les problèmes de planéité entre le support et la carte de connexion.

Un autre but encore est d'abaisser le coût de fabrication d'un support de connexion.

Un autre but est d'assouplir le procédé de connexion entre deux supports par l'intermédiaire de boules, en offrant un choix entre plusieurs variantes de réalisation permettant une bonne adaptation du procédé à chaque cas.

Un autre but enfin est de pouvoir connecter les boules à un plan conducteur, de masse par exemple, fixé au film sur sa face portant les boules. La soudure et/ou la boule elle-même peut venir en contact avec le bord du plan au niveau de la traversée.

L'invention a pour objet un support de connexion de circuit intégré selon la revendication1.

Les caractéristiques et avantages de l'invention ressortent de la description qui suit, donnée à titre d'exemple et faite en référence aux dessins annexés.

Dans les dessins
- la figure 1 est une vue en coupe schématique axiale limitée à l'axe central d'un boîtier de circuit intégré fixé à un support de connexion, illustrant le procédé de connexion ;
- la figure 2 est une vue en coupe partielle similaire à celle de la figure 1, illustrant une première variante de réalisation d'un support de connexion du boîtier ;
- la figure 3 est une vue en coupe partielle schématique similaire à celle de la figure 3, illustrant une seconde variante de réalisation d'un support de connexion ; et
- la figure 4 est une vue en coupe partielle schématique similaire à celle de la figure 1, illustrant une variante de réalisation du support de connexion du boîtier ainsi qu'une variante du procédé de connexion entre deux supports de connexion par l'intermédiaire de boules.

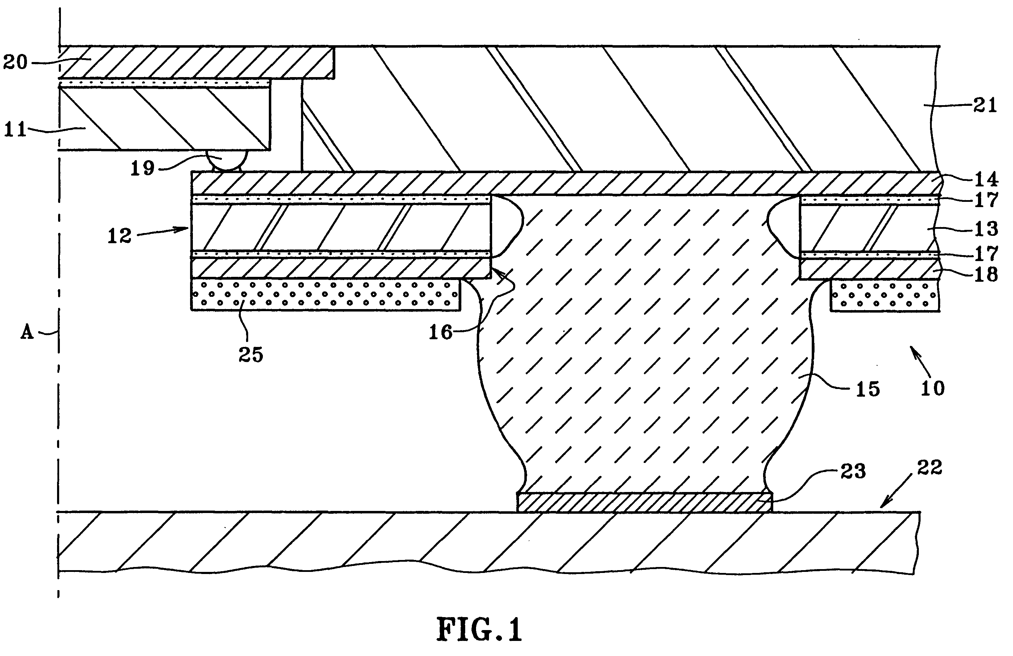

Dans la figure 1 est illustré un boîtier 10 pour un circuit intégré 11. Les dimensions du circuit intégré des éléments du boîtier ont été volontairement modifiées afin de bien les mettre en relief. Le circuit intégré 11 est monté sur un support de connexion 12. Le support 12 illustré est du type support ou ruban TAB (Tape-Automated Bonding) classique et comprend un film isolant 13, en polyimide par exemple, dont une face porte un ensemble de conducteurs 14 et l'autre face porte des boules 15. Les conducteurs 14 forment un faisceau convergeant vers l'axe central A indiqué sur la figure. Les boules 15 sont directement fixées dans des traversées 16 ménagées dans le film 13, dont le fond est formé par les conducteurs respectifs 14. Dans l'exemple illustré, le support 13 est du type à trois couches, à savoir une couche constituant le film 13 de polyimide ayant ordinairement une épaisseur comprise entre 75 et 125 µm, une couche conductrice composée des conducteurs 14 ayant une épaisseur couramment de l'ordre de 20 à 35 µm, et une couche adhésive 17 de l'ordre de 25 µm d'épaisseur. Cependant, dans l'exemple réalisé par les inventeurs le support 13 était du type classique à deux couches, évitant l'emploi de la couche adhésive 17 et permettant l'emploi d'un film 13 plus mince, typiquement de l'ordre de 50 µm. Les boules 15 ont couramment un diamètre de l'ordre de 600 à 700 µm et présentent donc un rapport d'environ 10 fois supérieur à l'épaisseur du film 13. Les boules peuvent être faites en un matériau non refusionnable, nécessitant un apport de soudure à plus bas point de fusion (de la brasure par exemple) pour leur fixation aux conducteurs 14. De préférence, elles sont faites en un matériau permettant le soudage par refusion. En pratique, dans l'exemple illustré, les boules 15 étaient faites en étain-plomb refusionnable. Compte tenu du rapport dimensionnel entre les boules et le film, les traversées 16 peuvent avoir une section inférieure au diamètre des boules. Cependant, si elles sont faites en un matériau refusionnable, elles peuvent avoir une dimension à peu près semblable car la refusion "écrase" légèrement les boules dans les traversées. Ce fait assure un bon contact de la soudure sur pratiquement toute la surface des conducteurs 14 conformés pour boucher les traversées 16. En plus de cet avantage, des boules peuvent être connectées à un plan conducteur 18, de masse par exemple, fixé au film 13 sur sa face portant les boules, comme indiqué. La soudure et/ou la boule elle-même peut venir en contact avec le bord du plan 18 au niveau de la traversée 16. Cependant, afin de limiter l'extension de soudure sur le plan conducteur 18, on peut par exemple déposer sur le plan conducteur 18 un masque 25 résistant à la soudure. Le dépôt de ce masque peut se faire par sérigraphie, qui ne constitue pas une opération coûteuse. Optionnellement, surtout si les boules sont faites en un matériau non refusionnable, les bords du plan qui doivent être connectés aux boules pourraient être légèrement prolongés à l'intérieur des traversées correspondantes. Afin d'éviter que des boules 15 viennent en contact avec le plan conducteur 18, il suffit donc d'écarter légèrement les bords du plan 18 autour de ces boules.

Le support conforme à l'invention peut aussi s'accommoder facilement à divers types de film et à tout matériau isolant pour sa constitution. Par exemple, en utilisant un film 13 plus épais, de 200 µm par exemple, les traversées 16 offriraient même l'avantage de servir de guide pour le placement des boules dans les traversées et auraient ainsi un rôle d'autoplacement. Ce rôle serait aussi profitable pour le placement et la soudure de boules 15 non refusionnables.

Dans le boîtier 10, les conducteurs 14 sont fixés aux bornes d'entrée-sortie 19 du circuit intégré 11. Bien que les bornes illustrées 19 soient disposées à la périphérie du circuit intégré, on pourrait aussi utiliser le mode de connexion connu sous le nom de "flip-chip" utilisant des bornes 19 réparties sur toute la face du circuit intégré et connectées directement aux conducteurs 14. D'autres techniques peuvent bien sûr être mis en oeuvre par l'invention. Par exemple, la fixation des conducteurs 14 aux bornes 19 peut être faite par l'intermédiaire de fils de liaison selon la technique bien connue sous le nom de "wire bonding". Dans le boîtier 10 illustré, la face opposée du circuit intégré 11 est mise en contact thermique avec une plaque de diffusion thermique 20 soutenue par un cadre isolant 21 entourant le circuit intégré 11. Dans l'exemple illustré, le cadre 21 est fixé par collage au film 13 par sa face supportant les fils 14.

Dans la figure 1, le boîtier 10 est fixé à une carte de connexion 22 par l'intermédiaire des boules 15. Ces boules sont soudées aux plages de connexion respectives 23 d'une face de la carte 22. En utilisant des boules refusionnables, la refusion des boules offre une meilleure tolérance de planéité des sommets des boules et augmente nettement, sous le poids du boîtier, le rendement de montage sur carte.

D'une manière générale, l'invention a donc pour objet un support de connexion 12 de circuit intégré 11, comprenant un film isolant 13 dont une face porte des conducteurs 14 et l'autre face porte des boules 15 directement fixées dans des traversées 16 du film 13 dont le fond est formé par les conducteurs respectifs, c'est-à-dire les conducteurs en eux-mêmes ou leurs extensions ou élargissements. Les conducteurs peuvent fermer partiellement les traversées respectives. La face portant des boules porte un plan conducteur connecté à au moins l'une des boules.

Bien que ces boules puissent être non refusionnables, elles sont de préférence faites en un matériau permettant la soudure par refusion. Par exemple, en utilisant des boules d'étain-plomb de composition proche de l'eutectique, la refusion permet de les fixer aux conducteurs ainsi qu'aux plages de connexion d'une carte et de s'accommoder à toutes les cartes du commerce.

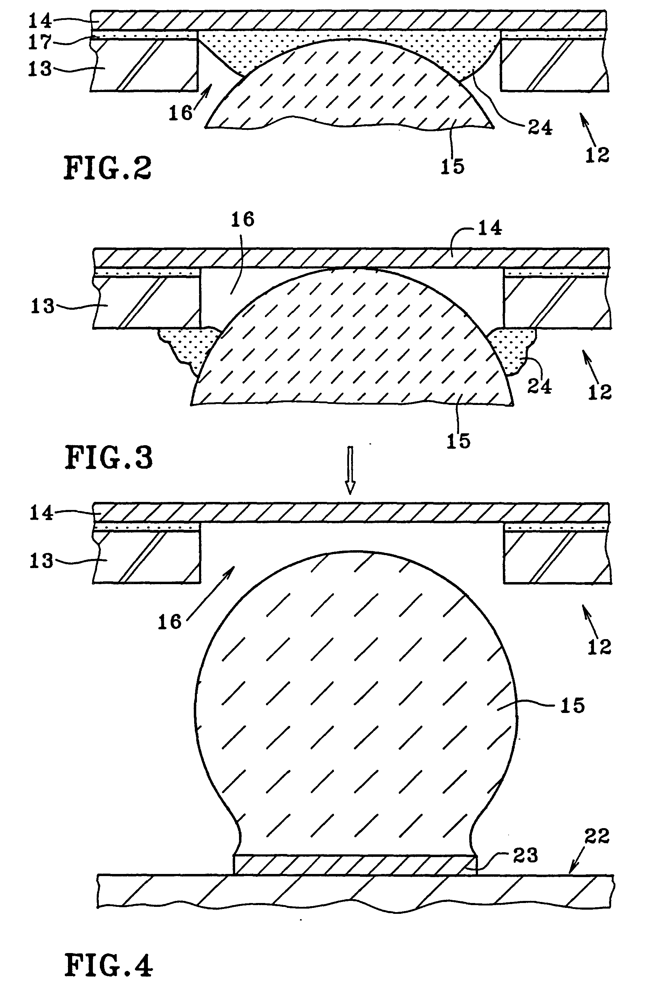

Selon l'exemple illustré dans la figure 1, les boules sont fixées par soudure aux conducteurs. Cependant, elles pourraient être fixées par une substance adhésive aux conducteurs 14 ou au support 12. Les figures 2 et 3 illustrent deux exemples de fixation par collage, où les éléments communs avec ceux de la figure 1 sont désignés par les mêmes chiffres de référence. Dans la figure 2, le conducteur du fond de chaque traversée 16 est pourvu d'une substance adhésive 24 sous forme de couche ou de goutte. Chaque boule est ensuite placée pour être fixée à l'adhésif 24. Lorsque les boules sont placées sur les plages 23 de la carte 22, la refusion des boules a lieu de chaque côté des boules et permet la fixation par soudure des boules aux conducteurs 14 du support 12 et aux plages 23 de la carte 22. L'adhésif 24 sera dans ce cas un adhésif conducteur soudable. Mais les boules pourraient être aussi fixées comme indiqué à la figure 3, qui est une variante de la figure 2. Dans la figure 3, chaque boule 15 est d'abord placée dans les traversées 16, puis fixée par un adhésif 24 déposé sur la face extérieure du support 12. Puisque les figures 2 et 3 ne sont données qu'à titre indicatif, le support 12 illustré n'a pas de plan conducteur 18. Cependant, il est clair qu'il pourrait y être ajouté sans problème. Si les boules sont rapprochées les unes des autres, l'adhésif 24 devra être isolant. Cependant, il pourrait être conducteur si elles sont suffisamment éloignées pour ne pas créer de court-circuit ou si on veut interconnecter certaines d'entre elles ou les connecter à un plan conducteur 18. En bref, dans les exemples représentés sur les figures 2 et 3, les boules sont faites en un matériau permettant le soudage par refusion et sont fixées par une substance adhésive. Dans la figure 2, les boules sont fixées aux conducteurs tandis que dans la figure 3 elles sont fixées à l'autre face du support.

Selon un autre exemple représenté sur la figure 4, les boules 15 sont d'abord fixées par soudure ou par de la colle sur les plages 23 de la carte 22. Le support 12 est seulement pourvu des traversées 16 avec ou sans le plan conducteur 18. Pour la connexion du support de connexion 12 à la carte de connexion 22 par l'intermédiaire des boules 15, il suffit de positionner les boules refusionnables 15 dans les traversées respectives et de refusionner les boules pour leur fixation aux conducteurs 14 et aux plages 23.

Dans la figure 4, les boules sont d'abord fixées sur des plages de connexion de l'autre support 22.

L'invention a donc pour objet corollaire un support de connexion 22 tel qu'une carte de circuits imprimés, ayant une face portant des plages de connexion 23 sur lesquelles sont fixées des boules en matériau refusionnable. La fixation des boules aux plages 23 peut être faite par une substance adhésive 24 comme indiqué à la figure 2 ou 3. Ce cas permettrait la livraison de cartes de connexion 22 pourvues des boules 15, la refusion des boules étant faite ultérieurement lors du montage du support 12 ou du boîtier 10.

Dans les figures 1 à 3, les boules sont d'abord fixées sur le support 12 défini précédemment. On a vu que dans le cas de la figure 1, les boules peuvent être faites en un matériau non refusionnable. L'invention a donc encore pour objet corollaire un support formant boîtier de circuit intégré et présentant des bornes d'entrée-sortie sortie sous forme de boules directement fixées dans des traversées d'un film, le fond des traversées étant formé par des conducteurs respectifs du boîtier.

## Revendications

1. Support de connexion (12) de circuit intégré (11) comprenant, un film isolant (13) dont une première face porte des conducteurs (14), des traversées (16) ménagées dans le film et traversant le film en débouchant sur la deuxième face du film opposée à la première face et ayant pour fond les conducteurs respectifs, et des boules (15), dans les traversées, fixées aux conducteurs pour servir de connexion à un second support (22), **caractérisé en ce que** ladite deuxième face du film porte un plan conducteur (18) connecté à au moins l'une des boules.

2. Support selon la revendication 1, **caractérisé en ce que** les boules sont faites en un matériau permettant leur soudage par refusion aux conducteurs (14) et au plan conducteur (18).

3. Support selon la revendication 1, **caractérisé en ce que** les boules sont faites en un matériau permettant le soudage par refusion et sont fixées par une substance adhésive (24) aux conducteurs (14) et au plan conducteur (18).

4. Support selon la revendication 1, **caractérisé en ce que** les boules sont faites en un matériau ne permettant pas le soudage par refusion et sont fixées par de la soudure aux conducteurs (14) et au plan conducteur (18).

5. Support selon l'une des revendications 1 à 4, **caractérisé en ce que** le plan conducteur (18) est pourvu d'un masque (25) résistant à la soudure.

6. Support selon l'une des revendications 1 à 5, **caractérisé en ce que** la connexion du plan conducteur (18) à au moins l'une des boules (15) est faite par la mise en contact de la boule ou de la soudure de la boule avec le bord du plan conducteur au niveau de la traversée (16) correspondante.

7. Support selon la revendication 6, **caractérisé en ce que** le bord du plan conducteur (18) est prolongé à l'intérieur de la traversée (16).

8. Support selon l'une des revendications 1 à 7, **caractérisé en ce que** les bords du plan conducteur (18) sont écartés autour des boules (15) non connectées au plan conducteur.

9. Support selon l'une des revendications 1 à 8, **caractérisé en ce que** les conducteurs (14) sont connectés aux bornes (19) du circuit intégré (11).

10. Boîtier de circuit intégré, **caractérisé en ce que** le circuit intégré (11) est fixé à un support de connexion tel que défini par l'une des revendications précédentes.

## Claims

1. Connection mount (12) for an integrated circuit (11) comprising an insulating film (13), a first side of which carries conductors (14), via holes (16) made in the film and passing through the film so as to open out on the second face of the film opposite the first face and having the respective conductors as its bottom, and balls (15), inside the via holes, fixed to the conductors so as to serve as a connection to a second mount (22), **characterised in that** said second face of the film carries a conductive plane (18) connected to at least one of the balls

2. Mount according to Claim 1, **characterised in that** the balls are made of a material that will allow them to be soldered by remelting to the conductors (14) and to the conductive plane (18).

3. Mount according to Claim 1, **characterised in that** the balls are made of a material that will allow them to be soldered by remelting and are fixed by an adhesive substance (24) to the conductors (14) and to the conductive plane (18).

4. Mount according to Claim 1, **characterised in that** the balls are made of a material that does not allow them to be soldered by remelting and are fixed by soldering to the conductors (14) and to the conductive plane (18).

5. Mount according to one of Claims 1 to 4, **characterised in that** the conductive plane (18) is provided with a mask (25) resistant to soldering.

6. Mount according to one of Claims 1 to 5, **characterised in that** the conductive plane (18) is connected to at least one of the balls (15) by putting the ball into contact with or by soldering the ball to the edge of the conductive plane in the area of the corresponding via hole (16).

7. Mount according to Claim 6, **characterised in that** the edge of the conductive plane (18) is extended inside the via hole (16).

8. Mount according to one of Claims 1 to 7, **characterised in that** the edges of the conductive plane (18) are moved away around those balls (15) that are not connected to the conductive plane.

9. Mount according to one of Claims 1 to 8, **characterised in that** the conductors (14) are connected to the terminals (19) of the integrated circuit (11).

10. Integrated circuit housing, **characterised in that** the integrated circuit (11) is fixed to a connection mount as defined by one of the preceding claims.

## Patentansprüche

1. Anschlußträger (12) für integrierte Schaltung (11), mit einem Isolierfilm (13), wovon eine erste Fläche Leiter (14) trägt, Durchführungen (16), die im Film ausgebildet sind, durch den Film verlaufen, in die zweite Fläche des Films, die der ersten Fläche gegenüberliegt, münden und als Boden die jeweiligen Leiter besitzen, sowie Kugeln (15) in den Durchführungen, die an den Leitern befestigt sind, um als Anschluß an einen zweiten Träger (22) zu dienen, **dadurch gekennzeichnet, daß** die zweite Fläche des Films eine Leiterebene (18) trägt, die an wenigstens eine der Kugeln angeschlossen ist.

2. Träger nach Anspruch 1, **dadurch gekennzeichnet, daß** die Kugeln aus einem Werkstoff hergestellt sind, der ihr Verschweißen durch Aufschmelzen auf die Leiter (14) und auf die Leiterebene (18) ermöglicht.

3. Träger nach Anspruch 1, **dadurch gekennzeichnet, daß** die Kugeln aus einem Werkstoff hergestellt sind, der das Verschweißen durch Aufschmelzen ermöglicht, und **daß** sie durch eine Klebstoffsubstanz (24) an den Leitern (14) und an der Leiterebene (18) befestigt sind.

4. Träger nach Anspruch 1, **dadurch gekennzeichnet, daß** die Kugeln aus einem Werkstoff hergestellt sind, der das Verschweißen durch Aufschmelzen nicht ermöglicht, und **daß** sie durch Lötmittel an den Leitern (14) und an der Leiterebene (18) befestigt sind.

5. Träger nach einem der Ansprüche 1 bis 4, **dadurch gekennzeichnet, daß** die Leiterebene(18) mit einer gegenüber dem Lötmittel resistenten Maske (25) versehen sind.

6. Träger nach einem der Ansprüche 1 bis 5, **dadurch gekennzeichnet, daß** der Anschluß der Leiterebene (18) an wenigstens eine der Kugeln (15) durch Herstellen eines Kontakts zwischen der Kugel oder dem Lötmittel der Kugel und dem Rand der Leiterebene auf Höhe der entsprechenden Durchführung (16) ausgebildet ist.

7. Träger nach Anspruch 6, **dadurch gekennzeichnet, daß** der Rand der Leiterebene (18) in die Durchführung (16) hinein verlängert ist.

8. Träger nach einem der Ansprüche 1 bis 7, **dadurch gekennzeichnet, daß** die Ränder der Leiterebene (18) um die nicht an die Leiterebene angeschlossenen Kugeln (15) entfernt sind.

9. Träger nach einem der Ansprüche 1 bis 8, **dadurch gekennzeichnet, daß** die Leiter (14) an die Anschlüsse (19) der integrierten Schaltung (11) angeschlossen sind.

10. Gehäuse für integrierte Schaltung, **dadurch gekennzeichnet, daß** die integrierte Schaltung (11) an einem Anschlußträger, wie er in einem der vorhergehenden Ansprüche definiert ist, befestigt ist.
